# FASCICULE DE BREVET EUROPEEN

(11) **EP 3 670 439 B1**
(45) Date de publication et mention de la délivrance du brevet: **11.05.2022**
(21) Numéro de dépôt: 19217628.7
(22) Date de dépôt: 18.12.2019
(51) Int. Cl.: B81B 3/00, G01P 15/08, G02B 26/08, H04R 19/00, G01P 15/18, G01P 15/125

(54) **ARTICULATION POUR SYSTEMES MICRO ET NANOELECTROMECANIQUES A DEPLACEMENT HORS-PLAN OFFRANT UNE NON-LINEARITE REDUITE**
GELENK FÜR MIKRO- UND NANOELEKTRISCHE SYSTEME MIT BEWEGUNGEN AUSSERHALB DER EBENE, DAS EINE REDUZIERTE NICHTLINEARITÄT ERMÖGLICHT
JOINT FOR MICRO- AND NANO-ELECTROMECHANICAL SYSTEMS WITH OUT-OF-PLANE MOVEMENT OFFERING REDUCED NON-LINEARITY

(30) Priorité: 20.12.2018 FR 1873561
(43) Date de publication de la demande: 24.06.2020
(73) Titulaire: Commissariat à l'énergie atomique et aux énergies alternatives, 75015 Paris (FR)
(72) Inventeur: DAGHER, Samer, 38054 Grenoble Cedex 09 (FR); JOET, Loïc, 38054 Grenoble Cedex 09 (FR)
(74) Mandataire: Brevalex

(56) Documents cités:
- WO-A1-01/98786
- US-A1- 2013 107 339

## Description

### DOMAINE TECHNIQUE ET ÉTAT DE LA TECHNIQUE ANTÉRIEURE

La présente invention se rapporte à une articulation pour systèmes micro et nanoélectromécaniques offrant une non-linéarité au moins réduite et à un système mettant en œuvre au moins deux telles articulations.

Les systèmes microélectromécaniques ou MEMS (microelectromechanical systems en terminologie anglo-saxonne) et les systèmes micro et nanoélectromécaniques ou systèmes M&NEMS (micro & nanoelectromechanical systems en terminologie anglo-saxonne) sont utilisés pour réaliser des capteurs ou des actionneurs. Ils comportent au moins un élément mobile par rapport à un substrat. Par exemple dans le cas d'un capteur, le déplacement de la partie mobile ou masse est mesurée et peut être traduit en une caractéristique à détecter, par exemples une accélération, et dans le cas d'un actionneur, l'élément mobile est déplacé par exemple au moyen de forces électrostatiques, par exemple pour déplacer un micromiroir.

L'élément mobile est suspendu par rapport au substrat et suivant les applications on peut souhaiter qu'il ait un déplacement dans le plan du système ou un déplacement hors-plan, i.e. orthogonalement au plan du système.

Lorsque l'élément mobile a un déplacement de grande amplitude dans la direction hors-plan, la zone de liaison peut présenter une non-linéarité importante.

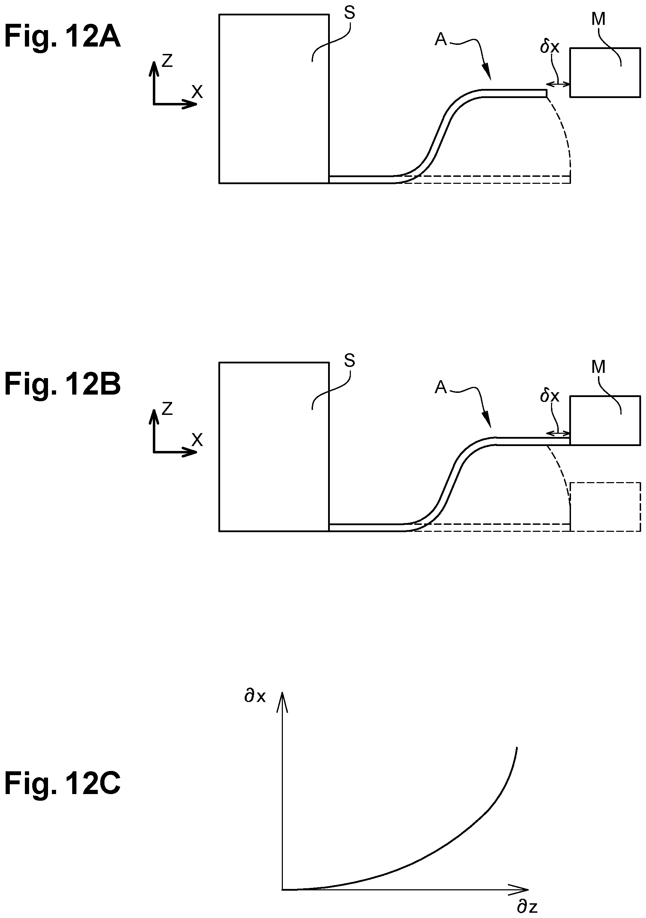

Ce comportement non-linéaire est illustré sur les figures 12A à 12C. La masse mobile M est suspendue au substrat S par une articulation A formée par une membrane fine. Le déplacement dans la direction Z de la masse M provoque une déformation de la membrane au premier ordre dans la direction Z et au second ordre dans la direction X. Lorsque le déplacement de la masse dans la direction Z est important, l'allongement de la membrane dans la direction X (figure 12B) n'est plus négligeable. Il en résulte que la force de rappel exercée par la membrane sur la masse est non linéaire (figure 12C) et varie de manière importante avec le déplacement dans la direction Z. Cette non-linéarité peut affecter sensiblement la réponse du système, par exemple dans le cas d'un capteur, et peut rendre celui-ci peu fiable.

Le document WO 01/98786 décrit un accéléromètre comportant une masse reliée à un support par des poutres élastiques en forme de U reliées à la masse et au support par les extrémités libres des branches du U.

### EXPOSÉ DE L'INVENTION

C'est par conséquent un but de la présente invention d'offrir une articulation pour système MEMS ou M&NEMS assurant un guidage des déplacements hors-plans d'au moins deux parties mobiles l'une par rapport à l'autre, tout en présentant une non-linéarité au moins réduite même pour des déplacements hors-plans de grandes amplitudes.

Le but énoncé ci-dessus est atteint par une articulation ,telle que définie par la revendication 1, destinée à relier un premier élément et un deuxième élément d'un système MEMS ou M&NEMS, comportant une première partie rigide dans les trois directions de l'espace, au moins une deuxième partie reliée à la première partie et destinée à être reliée au premier élément, la deuxième partie étant apte à être déformée en flexion dans la direction hors-plan, et au moins une troisième partie reliée à la première partie et apte à être déformée en flexion dans la direction hors-plan, la deuxième et la troisième parties s'étendant au repos sur le même plan.

Les deuxième et troisième parties sont agencées par rapport à la première partie et aux deux éléments du système de sorte que, lors du déplacement relatif du premier élément et du deuxième élément dans la direction hors-plan, la deuxième partie et la troisième partie subissent chacune une déformation dans le plan, les amplitudes des déformations des deuxième et troisième parties dans le plan sont au moins proches et se compensent au moins en partie. De manière très avantageuse, les déformations dans le plan des deuxième et troisième parties sont identiques et se compensent entièrement.

Il en résulte que l'articulation subit peu, voire pas de déformation dans le plan au niveau des attaches au premier et deuxième élément, et présente donc peu ou pas de non-linéarité et ceci même lors de déplacements hors-plans de grande amplitude. En effet quel que soit le déplacement hors-plan relatif des deux éléments, les déformations dans le plan de l'articulation sont au moins en partie compensées.

En d'autres termes, de manière très avantageuse on réalise une articulation qui auto-annule au moins en partie les déformations dans le plan responsables d'un comportement non linéaire. L'invention ne limite pas la déformation dans le plan, mais compense celle-ci au moins en partie au moyen d'une articulation composite.

L'articulation selon l'invention présente en outre l'avantage de permettre d'ajuster aisément sa rigidité en choisissant les dimensions des deuxième et troisième parties.

De manière avantageuse, les deuxième et troisième parties sont des membranes et ont les mêmes dimensions, présentant ainsi les mêmes comportements mécaniques lorsqu'elles sont déformées en flexion.

De manière avantageuse, un système M&NEMS comporte au moins deux articulations ce qui assure un très bon guidage dans la direction hors-plan et au moins un guidage dans une direction dans le plan.

De manière encore plus avantageuse, le système M&NEMS comporte au moins trois articulations, et encore plus avantageusement quatre articulations, permettant d'assurer un guidage dans la direction hors-plan et un très bon maintien dans les deux directions du plan.

La présente invention a alors pour objet une articulation telle que définie dans la revendication 1.

La présente invention a également pour objet un système microélectromécanique comportant un premier élément et un deuxième élément mobiles l'un par rapport dans une direction hors-plan, et au moins deux articulations selon l'invention, chacune ancrée au premier élément et au deuxième élément, et les articulations sont orientées de sorte que la première direction soit la direction hors-plan et les deuxième et troisième directions soient les directions dans le plan.

### BRÈVE DESCRIPTION DES DESSINS

La présente invention sera mieux comprise sur la base de la description qui va suivre et des dessins en annexe sur lesquels:
La figure 1 est une représentation en perspective d'un exemple d 'articulation, les éléments entre lesquels l'articulation est disposée étant représentés en pointillés.
La figure 2 est une vue de détail de la figure 1.
La figure 3 est une vue de face de l'articulation de la figure 1.
La figure 4 est une vue de dessus de l'articulation de la figure 1.
La figure 5A est une vue de côté représentant schématiquement la deuxième partie de l'articulation de la figure 1 dans un état déformé.
La figure 5B est une vue de côté représentant schématiquement la troisième partie de l'articulation de la figure 1 dans un état déformé.
La figure 6 est une vue en perspective d'un exemple de système M&NEMS comportant deux articulations de la figure 1 dans une position hors-plan.
La figure 7 est une représentation en perspective d'un autre exemple d'articulation, les éléments entre lesquels l'articulation est disposée étant représentés en pointillés.
La figure 8 est une vue de détail de la figure 7.
La figure 9 est une vue de face de l'articulation de la figure 7.
La figure 10 est une vue de dessus de l'articulation de la figure 7.
La figure 11 est une vue en perspective d'un exemple de système M&NEMS comportant deux articulations de la figure 7 dans une position hors-plan.
La figure 12A et la figure 12B sont des vues de côté d'un système MEMS de l'état de la technique à l'état repos et dans un état où la masse s'est déplacée dans la direction hors-plan et illustrant l'allongement de l'articulation.
La figure 12C est une représentation graphique de l'allongement de l'articulation des figures 12A et 12B, dans la direction X en fonction du déplacement de la masse dans la direction Z.

### EXPOSÉ DÉTAILLÉ DE MODES DE RÉALISATION PARTICULIERS

Dans la présente demande, on désigne par « système microélectromécanique » ou « système MEMS », un système micro et/ou nanoélectromécanique, i.e. comportant des éléments ayant des dimensions micrométriques et/ou des éléments ayant des dimensions nanométriques.

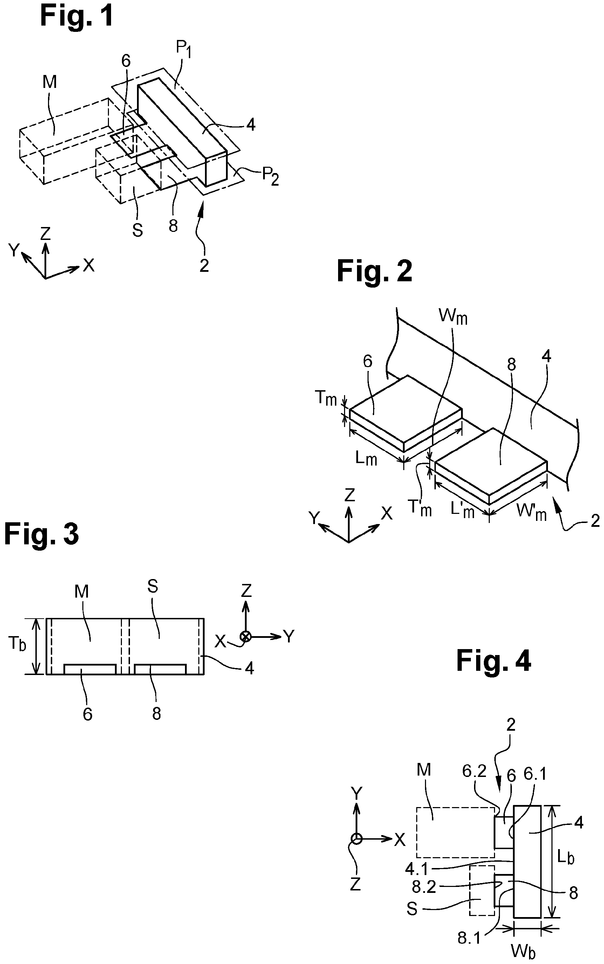

Sur les figures 1 à 4, on peut voir un exemple d'une articulation 2 selon l'invention. En traits interrompus sont représentées une partie fixe ou substrat S d'un système microélectromécanique et une partie mobile ou masse M destinée à être suspendue au substrat S par l'articulation 2. Il sera compris que l'articulation peut réaliser l'articulation entre deux parties mobiles entre elles, et elles-mêmes mobiles par rapport à un substrat fixe.

L'articulation 2 est destinée à permettre un déplacement hors-plan de la partie mobile M.

Le plan du système est défini par les directions X et Y et correspond au plan moyen du système dans lequel s'étend la masse mobile M, c'est aussi le plan moyen de la partie fixe.

La direction hors-plan Z est orthogonale au plan du système.

Sur la figure 2 la masse et le substrat ne sont pas représentés.

L'articulation comporte une première partie rigide 4.

On entend par « partie ou élément rigide » un élément qui ne se déforme pas ou peu sous l'effet des contraintes généralement appliquées à un système MEMS dans le cas d'un capteur ou d'un actionneur dans un fonctionnement normal.

Dans l'exemple représenté, la première partie 4 a la forme d'une poutre parallélépipédique présentant une épaisseur Tb, une largeur Wb et une longueur Lb. La première partie s'étend dans la direction Z entre un premier plan P1 et un deuxième plan P2 parallèles entre eux.

L'épaisseur correspond à la dimension selon Z, la largeur correspond à la dimension selon X et la longueur correspond à la dimension selon Y.

Les dimensions Tb, Wb et Lb sont par exemple comprises entre quelques µm et quelques centaines de µm.

L'articulation comporte une deuxième partie 6 présentant une épaisseur Tm faible par rapport à sa longueur Lm et à sa largeur Wm, de sorte à permettre sa déformation en flexion selon la direction Z, de préférence 1/10<Tm/Wm<1/100 et 1/10<Tm/Lm<1/100.

Par exemple son épaisseur Tm est comprise entre une centaine de nm et quelques µm, sa longueur Lm et sa largeur Wm sont comprises entre quelques µm et quelques centaines de µm.

La deuxième partie 6 présente alors la forme d'une membrane qui est solidarisée par un premier bord 6.1 s'étendant selon la direction Y à un premier côté 4.1 de la première partie 4, et un deuxième bord 6.2 parallèle au premier bord 6.1 et destiné à être solidarisé à la masse M.

La deuxième partie 6 relie la première partie 4 et la masse M. Dans l'exemple représenté, la face inférieure de la deuxième partie est disposée au repos sur le plan P2 dans lequel se situe la face inférieure de la première partie 4 dans la représentation des figures 1 à 4. En outre, dans l'exemple représenté la face inférieure de la masse M est également contenue dans le plan P2.

Sur les figures 1 à 4, l'articulation comporte également une troisième partie 8 présentant une épaisseur Tm' faible par rapport à sa longueur Lm' et à sa largeur Wm' de sorte à permettre sa déformation en flexion selon la direction Z, de préférence 1/10<Tm'/Wm'<1/100 et 1/10<Tm'/Lm'<1/100.

La deuxième partie 6 et la troisième partie 8 sont configurées de sorte à présenter des comportements mécaniques proches ou identiques, lors d'un déplacement hors-plan de la partie mobile M par rapport au substrat S.

De préférence, les comportements mécaniques proches ou identiques sont obtenus en réalisant des deuxièmes et la troisième parties dans le même matériau ou des matériaux aux propriétés mécaniques proches, et ayant les mêmes dimensions, c'est-à-dire Tm = Tm', Lm = Lm' et Wm = Wm'. Les dimensions sont égales aux imprécisions liées au procédé de réalisation.

La troisième partie 8 présente alors également une forme de membrane qui est solidarisée par un premier bord 8.1 s'étendant selon la direction Y au premier bord 4.1 de la première partie 4, et un deuxième bord 8.2 parallèle au première bord 8.1 et destiné à être solidarisé au substrat S.

Les deuxième 6 et troisième 8 parties sont connectées au même côté de la première partie 4 et sont disposées l'une à côté de l'autre.

La face inférieure de la troisième partie 8 est également disposée au repos sur le plan P2 délimitant la face inférieure de la première partie 4 dans la représentation des figures 1 à 4. Les faces inférieures de la deuxième partie 6 et la troisième partie 8 sont au repos situées sur le même plan P2 orthogonal à la direction hors-plan.

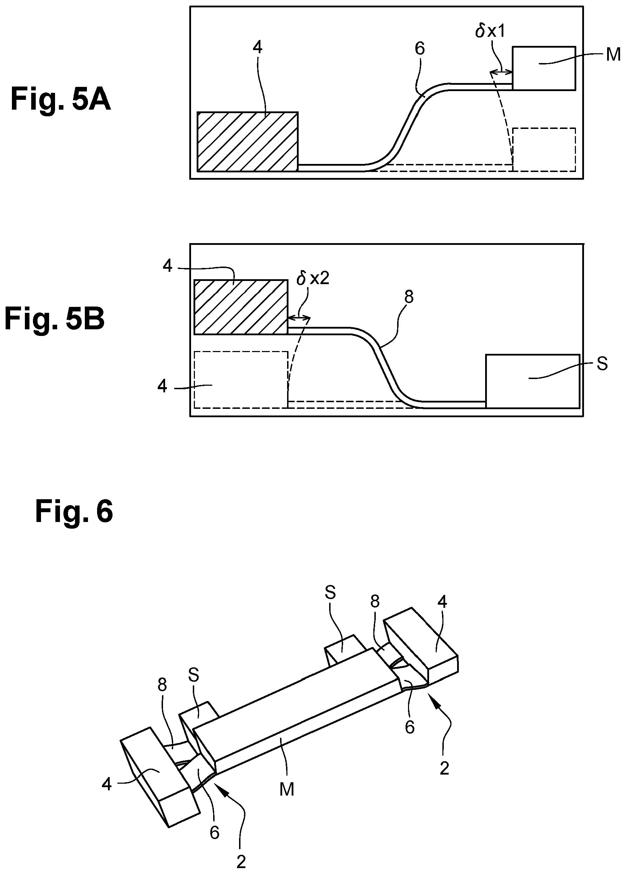

Sur la figure 6, on peut voir un système MEMS 10 mettant en œuvre deux articulations 2. Les articulations 2 sont ancrées sur la partie mobile M de manière symétrique par rapport à un plan médian de la partie mobile M parallèle au plan YZ.

Les deuxièmes parties de chaque articulation sont ancrées sur des faces parallèles M.1, M.2 de la partie mobile M, et les troisièmes parties sont ancrées sur la partie fixe S.

Dans la représentation de la figure 6, la partie mobile M a un mouvement hors-plan vers le haut, les deuxièmes parties et troisièmes parties sont déformées en flexion.

Le fonctionnement de l'articulation va maintenant être décrit en utilisant les figures 5A et 5B qui montrent de manière séparée la déformation d'une deuxième partie et d'une troisième partie.

Considérant l'application à un capteur, par exemple un accéléromètre destiné à mesurer l'accélération dans la direction Z.

Lorsque la partie mobile M a un déplacement hors-plan sous l'effet d'une accélération selon Z, les deuxièmes 6 et troisièmes 8 parties, du fait de leur faible épaisseur, sont déformées en flexion.

Les deuxièmes parties 6 sont déformées entre la première partie 4 et la masse (figure 5A), leur extrémité reliée à la masse subit une déformation δx1 dans le plan XY dans la direction X.

Les troisièmes parties 8 sont déformées entre la première partie 4 et le substrat S (figure 5B), leur extrémité reliée à la première partie subit une déformation δx2 dans le plan XY dans la direction X.

En réalisant des deuxième et troisième parties présentant des comportements mécaniques proches, les amplitudes des déformations δx1, δx2 sont proches, ainsi elles se compensent au moins en partie. Le comportement non-linéaire de l'articulation est alors fortement réduit.

Les dimensions et matériaux des deuxième et troisième parties sont déterminés de sorte que l'amplitude de la déformation δx1 est proche ou égale à l'amplitude de la déformation δx2

De manière préférée, en choisissant la deuxième partie 6 et la troisième partie 8 de chaque articulation de mêmes dimensions, l'amplitude de la déformation δx1 est égale à l'amplitude de la déformation δx2, elles se compensent complètement. L'articulation présente alors une rigidité hors plan pure et linéaire.

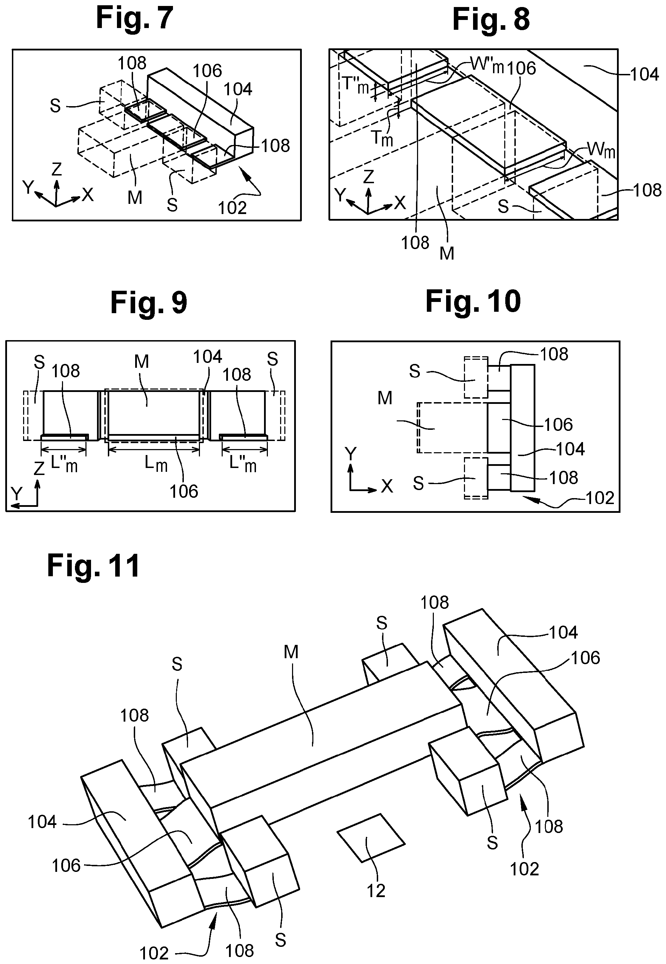

Sur les figures 7 à 10, on peut voir un autre exemple d'articulation 102 dans lequel l'articulation comporte deux troisièmes parties 108 disposées de part et d'autre de la deuxième partie 106. Dans cet exemple avantageux, les deux troisièmes parties 108 ont la même longueur Lm" et celle-ci est égale à la moitié de la longueur Lm de la deuxième partie 106 et les autres dimensions Wm" et Tm" des deux troisièmes sont identiques à celles Wm et Tm de la deuxième partie 106. Les deux troisièmes parties de largeur Lm" = 2 Lm sont mécaniquement équivalentes à une seule troisième partie de largeur Lm et subissant donc la même déformation dans le plan δx2.

Il sera compris que la deuxième partie d'une certaine longueur peut elle aussi être remplacée par plusieurs deuxièmes parties de même dimension équivalente.

La dimension équivalente dans la direction Y de la ou des deuxièmes parties est égale à la dimension équivalente dans la direction Y de la ou des troisièmes parties.

On entend par « dimension équivalente » de la deuxième partie ou de la troisième dans la direction Y, la dimension de la deuxième partie ou de la troisième partie dans la direction Y ou la somme des dimensions des deuxièmes parties ou des dimensions des troisièmes parties dans la direction Y.

En variante l'articulation comporte deux deuxièmes parties de part et d'autre d'une troisième partie. En variante encore l'articulation comporte m deuxièmes parties et n troisièmes parties, avec m et n des entiers strictement positifs, m et n pouvant être égaux ou différents. Les deuxièmes parties et les troisièmes parties étant alternées ou non.

Dans l'exemple représenté, les faces inférieures des deuxième(s) et troisième(s) parties et la face inférieure de la première partie sont dans le même plan. En variante, les faces inférieures des deuxième(s) et troisième(s) parties sont situées dans un plan quelconque parallèle au plan XY le long de la direction Z.

En outre dans l'exemple représenté, la face inférieure de la deuxième partie est dans le plan contenant la face inférieure de la partie mobile. En variante, la face supérieure de la deuxième partie est dans le plan de la face supérieure de la partie mobile ou dans tout plan intermédiaire

Sur la figure 11, on peut voir un exemple de structure MEMS comportant deux articulations 102 selon l'invention, disposées chacune à une extrémité de la masse M le long de la direction X. Le guidage en translation est ainsi amélioré. En outre le maintien dans la direction Y est amélioré.

Dans un autre exemple, la structure MEMS comporte au moins trois articulations disposées à 120° l'une de l'autre, de manière encore plus avantageuse quatre articulations disposées à angle droit les unes par rapport aux autres. Les poutres des premières parties sont orientées à 120° deux à deux. La mise en œuvre d'au moins trois articulations améliore le maintien dans les deux directions du plan.

Dans un autre exemple, plusieurs articulations sont disposées côte à côte le long d'un côté de la partie mobile, par exemple deux articulations côte à côte. De préférence, dans le cas d'une masse de forme rectangulaire ou carrée en vue de dessus, les articulations sont disposées de manière symétrique au niveau des côtés parallèles.

En outre des nombres différents d'articulations ancrées aux bords de la partie mobile peuvent être mis en œuvre.

De préférence, les deuxièmes et/ou troisièmes parties sont structurées et/ou ajourées pour présenter des formes assurant une grande souplesse selon Z et une grande raideur dans le plan, par exemple des croisillons ou treillis sont réalisées.

Grâce à l'invention, la rigidité de l'articulation peut être ajustée finement en choisissant les dimensions des deuxièmes et troisièmes parties.

L'articulation selon l'invention peut être mise en œuvre dans des capteurs MEMS, pour cela des moyens de détection du mouvement de la masse selon Z sont prévus, par exemple des moyens capacitifs ou des jauges de contraintes, par exemple des jauges piézorésistives, piézoélectriques ou résonantes, ou des couches piézoélectriques.

L'articulation selon l'invention peut être mise en œuvre dans des actionneurs MEMS, pour cela des moyens d'actionnement 12 de la partie mobile dans la direction Z sont prévus, par exemple des moyens électrostatiques représentés schématiquement sur la figure 11. Les moyens électrostatiques comportent au moins une paire d'électrodes, l'une étant formée sur le substrat sous la partie mobile M et l'autre électrode étant formée sur la partie mobile M en regard de l'électrode sur le substrat S. L'application d'une différence de potentiels génère des forces électrostatiques entre les deux électrodes et donc un déplacement hors-plan de la masse mobile M par rapport au substrat S.

De manière très avantageuse, un système MEMS comportant les articulations selon l'invention peut être utilisé pour réaliser un microphone. L'articulation et le système MEMS peuvent être avantageusement fabriqués par des procédés connus de la microélectronique par dépôt de couches et gravures. Par exemple les exemples de procédé de fabrication décrits dans le document FR2941533 peuvent être mis en œuvre pour réaliser un tel système MEMS.

Par exemple, les membranes sont formées par la couche supérieure d'un substrat silicium sur isolant ou SOI (Silicon on Insulator en terminologie anglo-saxonne) et la première partie est réalisées par gravure et libération. En variante, les membranes sont réalisées par le dépôt d'une couche d'une épaisseur de quelques centaines de nm et la première partie est réalisée par gravure et libération.

Le système est par exemple réalisé en matériau semi-conducteur, tel que le silicium ou le SiGe.

## Revendications

1. Articulation entre au moins un premier élément et au moins un deuxième élément d'un système microélectromécanique, lesdits premier élément (S) et deuxième éléments (M) étant mobiles l'un par rapport à l'autre au moins dans une direction hors-plan, ladite articulation comportant une première partie (4, 104) rigide, au moins une deuxième partie (6, 106) solidaire d'une première face de la première partie (4, 104) par une extrémité et destinée à être ancrée au premier élément ou au deuxième élément par une deuxième extrémité, les première et deuxième extrémités de la deuxième partie étant considérées le long d'une deuxième direction (X), ladite deuxième partie (6, 106) étant configurée pour être déformable en flexion dans une première direction (Z), au moins une troisième partie (8, 108) solidaire de la première face de la première partie (4, 104) par une première extrémité, et destinée à être ancrée au deuxième élément (M) ou au premier élément (S) par une deuxième extrémité, les première et deuxième extrémités de la troisième partie (8, 108) étant considérées le long de la deuxième direction (X), la troisième partie (8, 108) étant configurée pour se déformer en flexion dans la première direction (Z), et, dans un état non déformé la deuxième partie (6, 106) et la troisième partie (8, 108) étant situées sur un même plan (P2) orthogonal à la première direction (Z), **caractérisée en ce que** la deuxième partie (6, 106) et la troisième partie (8, 108) présentent une épaisseur selon la première direction (Z) inférieure à l'épaisseur de la première partie (4, 104).

2. Articulation selon la revendication 1, dans laquelle les deuxième et troisième parties sont configurées pour présenter des déformations d'amplitudes proches ou identiques dans la deuxième direction (X), lors d'une déformation de l'articulation dans la première direction (Z).

3. Articulation selon la revendication 1 ou 2, comportant m deuxièmes parties et n troisièmes parties, avec m et n des entiers strictement positifs, m et n pouvant être égaux ou différents.

4. Articulation selon la revendication 3, dans laquelle les m deuxièmes parties et les n troisièmes parties présentent une dimension proche ou égale dans la première direction (Z), et dans laquelle la dimension équivalente des m deuxièmes parties dans une troisième direction (Y) orthogonale à la première direction (Z) et à la deuxième direction (X) est proche ou égale à la dimension équivalente dans la troisième direction (Y) des n troisièmes parties.

5. Articulation selon l'une des revendications 1 à 4, dans laquelle la première partie est une poutre dont la plus grande dimension s'étend dans la troisième direction (Y), la première partie présentant avantageusement des dimensions dans les première (Z), deuxième (X) et troisième (Y) directions comprises entre quelques µm et quelques centaines de µm.

6. Articulation selon l'une des revendications 1 à 5, dans laquelle la deuxième partie (6) présente une dimension dans la première direction (Z) réduite par rapport aux dimensions dans les autres directions.

7. Articulation selon l'une des revendications 1 à 6, dans laquelle les deuxième et troisième parties ont une dimension dans la première direction (Z) comprise entre une centaine de nm et quelques microns, une dimension dans la deuxième direction (X) comprise entre quelques µm et quelques centaines de µm et une dimension équivalente dans la troisième direction (Y) comprise entre quelques µm et quelques centaines de µm.

8. Articulation selon l'une des revendications 1 à 7, comportant une deuxième partie et deux troisièmes parties disposées de part et d'autre de la deuxième partie.

9. Articulation selon l'une des revendications 1 à 8, dans laquelle les deuxième et troisième parties sont solidaires chacune de la première face de la première partie en des zones distinctes.

10. Système microélectromécanique comportant un premier élément et un deuxième élément mobiles l'un par rapport dans une direction hors-plan, et au moins deux articulations selon l'une des revendications 1 à 9, chacune ancrée au premier élément (S) et au deuxième élément (M), et dans lequel les articulations sont orientées de sorte que la première direction soit la direction hors-plan et les deuxième et troisième directions soient les directions dans le plan.

11. Système microélectromécanique selon la revendication 10, dans lequel le premier élément (S) est une partie fixe du système.

12. Système microélectromécanique selon la revendication 10 ou 11, dans lequel les au moins deux articulations sont disposées symétriquement par rapport à un plan médian du deuxième élément (M), ledit plan médian s'étendant dans la direction hors-plan.

13. Système microélectromécanique selon la revendication 10, 11 ou 12, comportant au moins quatre articulations et dans lequel les premières parties de chaque articulation sont des poutres, les axes des poutres étant orthogonaux deux à deux.

14. Système microélectromécanique selon l'une des revendications 10 à 13, comportant des moyens de mise en mouvement (12) du deuxième élément au moins dans une direction hors-plan.

15. Système microélectromécanique selon l'une des revendications 10 à 14, formant un microphone.

## Patentansprüche

1. Gelenk zwischen mindestens einem ersten Element und mindestens einem zweiten Element eines mikroelektromechanischen Systems, wobei das erste Element (S) und zweite Element (M) relativ zueinander mindestens in einer Richtung außerhalb der Ebene beweglich sind, wobei das Gelenk einen ersten starren Teil (4, 104), mindestens einen zweiten Teil (6, 106), der durch ein Ende fest mit einer ersten Seite des ersten Teils (4, 104) verbunden ist und dazu bestimmt ist, am ersten Element oder am zweiten Element durch ein zweites Ende verankert zu werden, wobei das erste und zweite Ende des zweiten Teils entlang einer zweiten Richtung (X) angenommen werden, wobei der zweite Teil (6, 106) konfiguriert ist, um in einer ersten Richtung (Z) biegeverformbar zu sein, mindestens einen dritten Teil (8, 108), der durch ein erstes Ende fest mit der ersten Seite des ersten Teils (4, 104) verbunden ist, und dazu bestimmt ist, an dem zweiten Element (M) oder an dem ersten Element (S) durch ein zweites Ende verankert zu werden, wobei das erste und zweite Ende des dritten Teils (8, 108) entlang der zweiten Richtung (X) angenommen werden, wobei der dritte Teil (8, 108) konfiguriert ist, um sich in der ersten Richtung (Z) biegsam zu verformen, und sich der zweite Teil (6, 106) und der dritte Teil (8, 108) in einem nicht verformten Zustand in einer selben Ebene (P2) orthogonal zur ersten Richtung (Z) befinden, **dadurch gekennzeichnet, dass** der zweite Teil (6, 106) und der dritte Teil (8, 108) eine Dicke in der ersten Richtung (Z) kleiner als die Dicke des ersten Teils (4, 104) aufweisen.

2. Gelenk nach Anspruch 1, wobei der zweite und dritte Teil konfiguriert sind, um Verformungen mit Amplituden aufzuweisen, die bei einer Verformung des Gelenks in der ersten Richtung (Z) in der zweiten Richtung (X) naheliegend oder identisch sind.

3. Gelenk nach Anspruch 1 oder 2, das m zweite Teile und n dritte Teile beinhaltet, wobei m und n streng positive ganze Zahlen sind, wobei m und n gleich oder unterschiedlich sein können.

4. Gelenk nach Anspruch 3, wobei die m zweiten Teile und die n dritten Teile eine Abmessung in der ersten Richtung (Z) naheliegend oder gleich aufweisen, und wobei die gleichwertige Abmessung der m zweiten Teile in einer dritten Richtung (Y) orthogonal zur ersten Richtung (Z) und zur zweiten Richtung (X) naheliegend oder gleich der gleichwertigen Abmessung in der dritten Richtung (Y) der n dritten Teile ist.

5. Gelenk nach einem der Ansprüche 1 bis 4, wobei der erste Teil ein Träger ist, dessen größte Abmessung sich in der dritten Richtung (Y) erstreckt, wobei der erste Teil vorteilhafterweise Abmessungen in der ersten (Z), zweiten (X) und dritten (Y) Richtung aufweist, die zwischen einigen µm und einigen hunderten µm liegen.

6. Gelenk nach einem der Ansprüche 1 bis 5, wobei der zweite Teil (6) eine Abmessung in der ersten Richtung (Z) aufweist, die in Bezug auf die Abmessungen in den anderen Richtungen verringert sind.

7. Gelenk nach einem der Ansprüche 1 bis 6, wobei der zweite und dritte Teil eine Abmessung in der ersten Richtung (Z) aufweisen, die zwischen etwa einhundert nm und einigen Mikrometern liegt, eine Abmessung in der zweiten Richtung (X), die zwischen einigen µm und einigen hunderten µm liegt und eine gleichwertige Abmessung in der dritten Richtung (Y), die zwischen einigen µm und einigen hunderten µm liegt.

8. Gelenk nach einem der Ansprüche 1 bis 7, das einen zweiten Teil und zwei dritte Teile beinhaltet, die beiderseits des zweiten Teils angeordnet sind.

9. Gelenk nach einem der Ansprüche 1 bis 8, wobei der zweite und dritte Teil jeweils fest mit der ersten Seite des ersten Teils in unterschiedlichen Zonen verbunden sind.

10. Mikroelektromechanisches System, das ein erstes Element und ein zweites Element beinhaltet, die relativ zueinander mindestens in einer Richtung außerhalb der Ebene beweglich sind, und mindestens zwei Gelenke nach einem der Ansprüche 1 bis 9, jeweils am ersten Element (S) und am zweiten Element (M) verankert, und wobei die Gelenke derart ausgerichtet sind, dass die erste Richtung die Richtung außerhalb der Ebene ist, und die zweite und dritte Richtung Richtungen in der Ebene sind.

11. Mikroelektromechanisches System nach Anspruch 10, wobei das erste Element (S) ein fester Teil des Systems ist.

12. Mikroelektromechanisches System nach Anspruch 10 oder 11, wobei die mindestens zwei Gelenke symmetrisch in Bezug auf eine Mittelebene des zweiten Elements (M) angeordnet sind, wobei sich die Mittelebene in der Richtung außerhalb der Ebene erstreckt.

13. Mikroelektromechanisches System nach Anspruch 10, 11 oder 12, das mindestens vier Gelenke beinhaltet, und wobei die ersten Teile eines jeden Gelenks Träger sind, wobei die Achsen der Träger paarweise orthogonal sind.

14. Mikroelektromechanisches System nach einem der Ansprüche 10 bis 13, das Mittel zum in Bewegung setzen (12) des zweiten Elements mindestens in einer Richtung außerhalb der Ebene beinhaltet.

15. Mikroelektromechanisches System nach einem der Ansprüche 10 bis 14, das ein Mikrofon bildet.

## Claims

1. Hinge between at least one first element and at least one second element of a microelectromechanical system, said first element (S) and second elements (M) being free to move relative to each other at least in an out-of-plane direction, said hinge comprising a rigid first part (4, 104), at least one second part (6, 106) fixed to a first face of the first part (4, 104) by one end and that is intended to be anchored to the first element or to the second element by a second end, the first and second ends of the second part being considered along a second direction (X), said second part (6, 106) being configured to be deformable in bending in a first direction (Z), at least one third part (8, 108) fixed to the first face of the first part (4, 104) by a first end, and that is intended to be anchored to the second element (M) or to the first element (S) by a second end, the first and second ends of the third part (8, 108) being considered along the second direction (X), the third part (8, 108) being configured to deform in bending in the first direction (Z), and in an undeformed state the second part (6, 106) and the third part (8, 108) being located in the same plane (P2) orthogonal to the first direction (Z), **characterized in that** the second part (6, 106) and the third part (8, 108) have a thickness along the first direction (Z) less than the thickness of the first part (4, 104).

2. Hinge according to claim 1, wherein the second and third parts are configured to have deformations with similar or identical amplitudes in the second direction (X), when the hinge is deformed in the first direction (Z).

3. Hinge according to claim 1 or 2, comprising m second parts and n third parts, where m and n are strictly positive integers, and m and n may be equal or different.

4. Hinge according to claim 3, wherein the dimensions in the first direction (Z) of the m second parts and the n third parts are similar or equal, and wherein the equivalent dimension of the m second parts in a third direction (Y) orthogonal to the first direction (Z) and to the second direction (X) is similar to or equal to the equivalent dimension of the n third parts in the third direction (Y).

5. Hinge according to one of claims 1 to 4, wherein the first part comprises a beam, the largest dimension of which extends along the third direction (Y), the dimensions of the first part in the first direction (Z), in the second (X) and in the third (Y) direction having advantageously dimensions between several µm and several hundred µm.

6. Hinge according to one of claims 1 to 5, wherein the dimension of the second part (6) in the first direction (Z) is less than its dimensions in the other directions.

7. Hinge according to one of claims 1 to 6, wherein the dimensions of the second and third parts in the first direction (Z) are between about a hundred nm and several microns, their dimension in the second direction (X) is between several µm and several hundred µm, and their equivalent dimension in the third direction (Y) is between several µm and several hundred µm.

8. Hinge according to one of claims 1 to 7, comprising one second part and two third parts arranged on each side of the second part.

9. Hinge according to one of claims 1 to 8, wherein the second and third parts are each fixed to the first face of the first part in distinct zones.

10. Microelectromechanical system comprising a first element and a second element free to move relative to each other in an out-of-plane direction, and at least two hinges according to one of claims 1 to 9, each anchored to the first element (S) and to the second element (M), and wherein the hinges are oriented such that the first direction is the out-of-plane direction and the second and third directions are in-plane directions.

11. Microelectromechanical system according to claim 10, wherein the first element (S) is a fixed part of the system.

12. Microelectromechanical system according to claim 10 or 11, wherein the at least two hinges are arranged symmetrically about a median plane of the second element (M), said median plane extending in the out-of-plane direction.

13. Microelectromechanical system according to claim 10, 11 or 12, comprising at least four hinges and wherein the first parts of each hinge are beams, the axes of the beams being orthogonal in pairs.

14. Microelectromechanical system according to one of claims 10 to 13, comprising at least one actuator (12) for moving the second element at least in an out-of-plane direction.

15. Microelectromechanical system according to one of claims 10 to 14, forming a microphone.
